(19) Europäisches Patentamt
European Patent Office
Office européen des brevets

(11) **EP 2 833 374 B1**

(12) **EUROPEAN PATENT SPECIFICATION**

(45) Date of publication and mention
of the grant of the patent:
**26.02.2020  Bulletin 2020/09**

(21) Application number: **13768470.0**

(22) Date of filing: **25.03.2013**

(51) Int Cl.:
*H01C 13/00* (2006.01)     *H01C 7/04* (2006.01)
*H01M 10/48* (2006.01)     *H01M 10/60* (2014.01)

(86) International application number:
**PCT/JP2013/059798**

(87) International publication number:
**WO 2013/147292 (03.10.2013 Gazette 2013/40)**

(54) **BATTERY WITH TEMPERATURE CONTROL FUNCTION**

BATTERIE MIT TEMPERATURREGELFUNKTION

BATTERIE AYANT UNE FONCTION DE RÉGLAGE DE LA TEMPÉRATURE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **30.03.2012   JP 2012081112**

(43) Date of publication of application:
**04.02.2015   Bulletin 2015/06**

(73) Proprietor: **Mitsubishi Materials Corporation
Tokyo 100-8117 (JP)**

(72) Inventors:
• **INABA, Hitoshi
Naka-shi
Ibaraki 311-0102 (JP)**
• **NAGATOMO, Noriaki
Naka-shi
Ibaraki 311-0102 (JP)**
• **TAKESHIMA, Kazuta
Naka-shi
Ibaraki 311-0102 (JP)**

(74) Representative: **Hoffmann Eitle
Patent- und Rechtsanwälte PartmbB
Arabellastraße 30
81925 München (DE)**

(56) References cited:
**EP-A1- 0 795 206       EP-A2- 1 333 521
CA-A1- 2 538 817       JP-A- H02 253 571
JP-A- 2006 219 739     JP-A- 2010 108 873
JP-A- 2011 044 621     JP-A- 2011 243 524
JP-A- 2012 018 786     US-A1- 2008 198 897
US-A1- 2009 087 723**

**Description**

BACKGROUND OF THE INVENTION

[Field of the Invention]

The present invention relates to a battery with a temperature control function capable of detecting and controlling the temperature of a Lithium (Li)-ion secondary battery or the like.

[Description of the Related Art]

Conventionally, a technology for controlling the temperature of a secondary battery such as a Li-ion battery or the like has been considered because the secondary battery cannot exert its original discharge performance at a low temperature. For example, Japanese Patent Laid-Open No. 2011-138672 discloses a battery system for controlling the temperature of a battery by heating the capacitor inside the battery using alternating current, thereby suppressing the performance deterioration of the battery.

In addition, Japanese Patent Laid-Open No. 2006-156024 discloses a battery system apparatus for controlling the temperature of a battery by heating the battery by a heater outside the battery using an auxiliary battery and direct current, thereby suppressing the performance deterioration of the battery. Furthermore, Japanese Patent Laid-Open No. 2010-245031 discloses a thin power storage device formed on a flexible substrate.

Documents cited during prosecution include EP 1 333 521, which discloses a battery apparatus with temperature sensors; and US 2008/0198897, which discloses a heater with temperature detecting device, battery structure with heater, and heater unit.

SUMMARY OF THE INVENTION

[Problems to be solved by the Invention]

The following problems still remain in the conventional technologies described above.

Specifically, in order to control the temperature of the thin Li-ion power storage device disclosed in Japanese Patent Laid-Open No. 2010-245031, a heater and a temperature detection device may be attached to the battery. However, when a temperature sensor is attached to one end of the secondary battery as in the technology disclosed in Japanese Patent Laid-Open No. 2006-156024, there is a disadvantage that the temperature measurement will be performed locally, and thus the temperature of the entire battery cannot be measured. In addition, since the heater is apart from the temperature sensor, it is difficult to measure the temperature of the heater to control its heating with high accuracy. Furthermore, the temperature sensor may be mounted on the heater as it is. In this case, however, when the temperature sensor is a temperature detecting element having a volume such as a chip thermistor or the like, there are problems that the responsivity of the sensor will be lowered, the thickness of the entire battery is increased, the surface becomes uneven, thereby precluding its housing into a narrow space, and the like.

The present invention has been made in view of the aforementioned circumstances, and an object of the present invention is to provide a battery with a temperature control function capable of accurately measuring the temperature of the battery to control its heating by a heater with high accuracy, which can be further thinned.

[Means for Solving the Problems]

According to the present invention, there is provided a battery with a temperature control function, comprising: a battery body; and a film heater with a temperature sensor arranged so as to cover at least a part of the surface of the battery body, wherein the film heater with a temperature sensor includes: an insulating film; one of a temperature sensor portion and a heater wire formed on the insulating film; and the other of the temperature sensor portion and the heater wire formed through an insulating layer on the one other than the other, wherein the heater wire is patterned on the insulating film or the insulating layer, and the temperature sensor portion has a thin film thermistor portion made of a thermistor material patterned directly under or above the heating region of the heater wire and on the insulating film or the insulating layer, and a pair of pattern electrodes formed at least on or under the thin film thermistor portion.

Since this battery with a temperature control function comprises the film heater with a temperature sensor having the temperature sensor portion and the heater wire, which is arranged so as to cover at least a part of the surface of the battery body, wherein the temperature sensor portion has the thin film thermistor portion, a temperature measurement and heating can be performed on a broad range of the surface of the battery body, whereby the temperature can be controlled with high accuracy and the circuit can be interrupted when abnormal heating occurs.

In addition, the thin film thermistor portion, which is arranged directly under or above the heating region of the heater wire, can accurately measure the average temperature of the entire heater wire or the entire battery body. Also, since the thin film thermistor portion is thinner and has a smaller volume as compared with a chip thermistor or a thermostat, the thin film thermistor portion has an excellent responsivity and has few ruggedness on the surface. Consequently, the battery can be thinned as a whole and thus can be easily mounted and housed in a small space. Further, since the thin film thermistor portion is formed directly under or above the heating region of the heater wire, the temperature sensor portion does not need to be provided in a place with no heater wire, whereby the area of the entire battery can be smaller. Furthermore, since the film heater with a temperature sensor can be easily and tightly bonded to the surface of the battery body with high flexibility, the temperature can be measured with high accuracy and high responsivity.

Note that the present invention is not limited to secondary batteries such as a lithium-ion secondary battery, a nickel-hydride battery, a nickel-cadmium battery, a lithium-polymer secondary battery and the like, but also includes a battery pack as the battery body in which one or more secondary batteries are housed in a case.

A battery with a temperature control function according to a second aspect of the present invention is characterized in that the heater wire and the thin film thermistor portion in the first aspect of the present invention extend so as to cover the entire outer periphery of the battery body.

Specifically, in this battery with a temperature control function, since the heater wire and the thin film thermistor portion extend so as to cover the entire outer periphery of the battery body, the average temperature in the entire outer periphery of the battery body can be measured. In particular, the average temperature of a battery body having a volume, such as a cylindrical, columnar, or rectangular battery, can be measured with higher accuracy.

A battery with a temperature control function according to a third aspect of the present invention is characterized in that, the temperature sensor portion in the first or second aspect of the present invention has the thin film thermistor portion made of a thermistor material patterned on the insulating film, and the pair of pattern electrodes formed at least on or under the thin film thermistor portion, wherein the heater wire is patterned on the insulating layer formed on the thin film thermistor portion.

Specifically, in this battery with a temperature control function, since the thin film thermistor portion is formed on the flat surface of the insulating film, the reliability to bending is improved as compared with the case where the thin film thermistor portion is formed through an insulating layer on the heater wire formed on the insulating film.

A battery with a temperature control function according to the fourth aspect of the present invention is characterized in that the thin film thermistor portion in the battery with a temperature control function according to any one of the first to third aspects of the present invention consists of a metal nitride represented by the general formula: $Ti_xAl_yN_z$ (where $0.70 \leq y/(x+y) \leq 0.95$, $0.4 \leq z \leq 0.5$, and $x+y+z = 1$), wherein the crystal structure thereof is a hexagonal wurtzite-type single phase.

The present inventors' serious endeavor carried out by focusing on an Al-N-based material among nitride materials found that an Al-N-based material having a good B constant and an excellent heat resistance may be obtained without firing by substituting the Al site with a specific metal element for improving electric conductivity and by ordering it into a specific crystal structure even though Al-N is an insulator and difficult to provide with an optimum thermistor characteristic (B constant: about 1000 to 6000 K).

Therefore, the present invention has been made on the basis of the above finding that when the thin film thermistor portion consists of a metal nitride represented by the general formula: $Ti_xAl_yN_z$ (where $0.70 \leq y/(x+y) \leq 0.95$, $0.4 \leq z \leq 0.5$, and $x+y+z = 1$), wherein the crystal structure thereof is a hexagonal wurtzite-type single phase, a good B constant and a high heat resistance can be obtained without firing.

Note that when the value of "y/(x+y)" (i.e., Al/(Ti+Al)) is less than 0.70, a wurtzite-type single phase cannot be obtained, but two coexisting phases of a wurtzite-type phase and a NaCl-type phase or a single phase of only a NaCl-type phase may be obtained. Consequently, a sufficiently high resistance and a high B constant cannot be obtained.

When the value of "y/(x+y)" (i.e., Al/(Ti+Al)) exceeds 0.95, the metal nitride material exhibits very high resistivity and extremely high electrical insulation. Therefore, such a metal nitride material is not applicable as a thermistor material.

When the value of "z" (i.e., N/(Ti+Al+N)) is less than 0.4, the amount of nitrogen contained in the metal is too small to obtain a wurtzite-type single phase. Consequently, a sufficiently high resistance and a high B constant cannot be obtained.

Furthermore, when the value of "z" (i.e., N/(Ti+Al+N)) exceeds 0.5, a wurtzite-type single phase cannot be obtained. This is because the correct stoichiometric ratio of N/(Ti+Al+N) in a wurtzite-type single phase without defects at the nitrogen site is 0.5.

[Effects of the Invention]

According to embodiments of the present invention, the following effects may be provided.

Specifically, since the battery with a temperature control function according to the present invention comprises the film heater with a temperature sensor having the temperature sensor portion and the heater wire, which is arranged so as to cover at least a part of the surface of the battery body, wherein the temperature sensor portion has the thin film thermistor portion, the temperature of the entire battery can be accurately measured to control its heating, the film sensor has an excellent responsivity and has few ruggedness on the surface, whereby the mounting and housing of the battery become easier. Therefore, the temperature of the battery body can be measured with high accuracy and high responsivity to control its heating, and thus the battery in a charged state can be controlled with high accuracy to prevent from being overheated, thereby securing high safety.

BRIEF DESCRIPTION OF THE DRAWINGS

In order to better understand the present invention, and to show how the same may be carried into effect, reference will now be made, by way of example only, to the accompanying drawings, in which:

FIG. 1 is a plan view illustrating a battery with a temperature control function according to a first embodiment of the present invention before being covered with an insulating tape.
FIG. 2 is a cross-sectional view of the battery of FIG. 1 cut along the A-A line.
FIG. 3 is a perspective view illustrating a battery body (a), a battery with a temperature control function before (b) and after (c) being covered with an insulating tape, according to a first embodiment.
FIG. 4 is a Ti-Al-N-based ternary phase diagram illustrating the composition range of a metal nitride material used in a battery with a temperature control function according to a first embodiment.
FIG. 5 is a plan view illustrating steps of forming a thin film thermistor portion and of forming a pair of pattern electrodes in a method for producing a battery with a temperature control function according to a first embodiment.
FIG. 6 is a plan view illustrating steps of forming an insulating layer and of forming a heater wire in a method for producing a battery with a temperature control function according to a first embodiment.
FIG. 7 is a perspective view illustrating a battery with a temperature control function as another example of a first embodiment before being covered with an insulating tape.
FIG. 8 is a perspective view illustrating a battery body (a), a battery with a temperature control function before (b) and after (c) being covered with an insulating tape, according to a second embodiment.
FIG. 9 is front and plan views illustrating a film evaluation element made of a metal nitride material for a thermistor according to Example of a battery with a temperature control function of the present invention.
FIG. 10 is a graph illustrating the relationship between a resistivity at 25 °C and a B constant for the materials according to Examples and Comparative Examples of the present invention.
FIG. 11 is a graph illustrating the relationship between an Al/(Ti+Al) ratio and a B constant for the materials according to Examples and Comparative Examples of the present invention.
FIG. 12 is a graph illustrating the result of X-ray diffraction (XRD) performed on a material according to the Example of the present invention having an Al/(Ti+Al) ratio of 0.84 and a strong c-axis orientation.
FIG. 13 is a graph illustrating the result of X-ray diffraction (XRD) performed on a material according to the Example of the present invention having an Al/(Ti+Al) ratio of 0.83 and a strong a-axis orientation.
FIG. 14 is a graph illustrating the result of X-ray diffraction (XRD) performed on a material according to the Comparative Example of the present invention having an Al/(Ti+Al) ration of 0.60.
FIG. 15 is a graph illustrating the relationship between an Al/(Ti+Al) ratio and a B constant for the comparison of a material exhibiting a strong a-axis orientation and a material exhibiting a strong c-axis orientation according to Examples of the present invention.
FIG. 16 is a cross-sectional SEM photograph of a material exhibiting a strong c-axis orientation according to Example of the present invention.
FIG. 17 is a cross-sectional SEM photograph of a material exhibiting a strong a-axis orientation according to Example of the present invention.

DESCRIPTION OF THE EMBODIMENTS

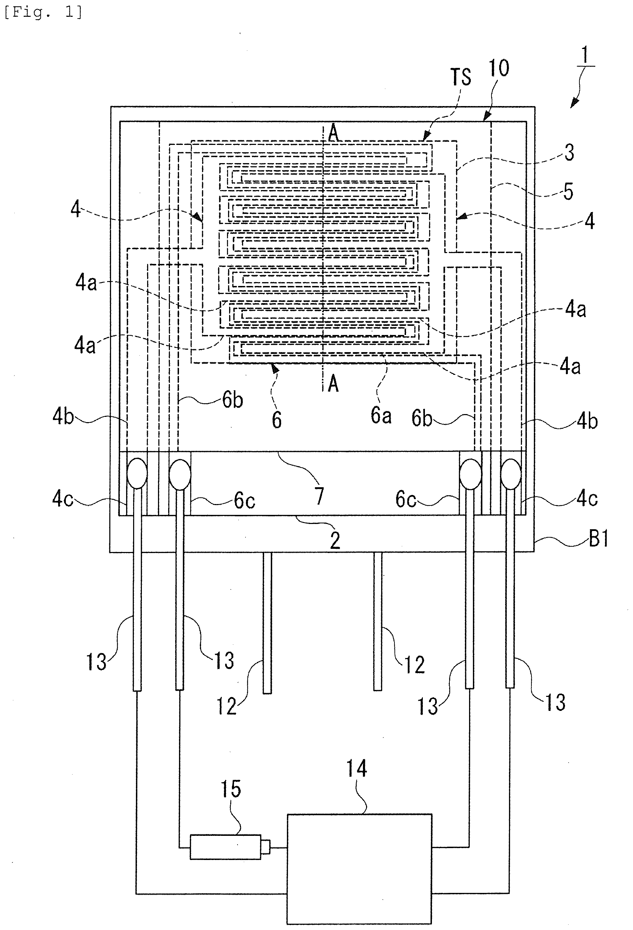

Hereinafter, a battery with a temperature control function according to a first embodiment of the present invention will be described with reference to FIGs. 1 to 7. In the drawings used in the following description, the scale of each component is changed as appropriate so that each component is recognizable or is readily recognized.

A battery 1 with a temperature control function according to the present embodiment includes a battery body B1 and a film heater 10 with a temperature sensor arranged so as to cover at least a part of the surface of the battery body B1 as shown in FIGs. 1 to 3. In the present embodiment, the film heater 10 with a temperature sensor is bonded to the battery body B1 so as to cover one side thereof entirely.

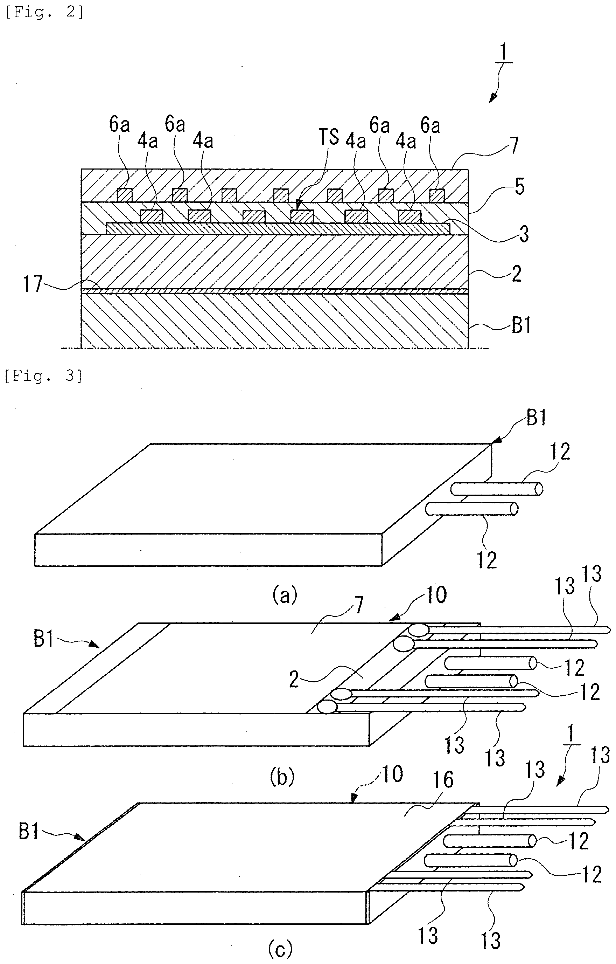

The battery body B1 is a thin rectangular (laminar) Li-ion secondary battery as shown in FIG. 3(a) for example, and has a pair of lead wires 12 for a battery which protrudes from one end surface thereof.

The film heater 10 with a temperature sensor includes an insulating film 2, a temperature sensor portion TS formed on the insulating film 2, and a heater wire 6 formed through an insulating layer 5 on the temperature sensor portion TS.

The heater wire 6 is patterned on the insulating layer 5. The temperature sensor portion TS has a thin film thermistor portion 3 made of a thermistor material patterned directly under the heating region of the heater wire 6 and on the insulating film 2, and a pair of pattern electrodes 4 formed at least on the thin film thermistor portion 3.

The insulating film 2 is a polyimide resin sheet formed in a band shape for example. The insulating film may be made of another material such as polyethylene terephthalate (PET), polyethylene naphthalate (PEN), or the like.

The pair of pattern electrodes 4 has a pair of opposed electrode portions 4a provided on the thin film thermistor portion 3.

This pair of pattern electrodes 4 has a Cr bonding layer (not shown) formed on the thin film thermistor portion 3 and an electrode layer (not shown) made of a noble metal formed on the bonding layer.

The pair of pattern electrodes 4 has a plurality pairs of opposed electrode portions 4a described above each of which is a pair of comb shaped electrode portions having a comb shaped pattern which is arranged so as to be opposed to each other, and a pair of linear extending portions 4b extending with the tip end portions thereof being connected to these comb shaped electrode portions 4a and the base end portions thereof being arranged at the end of the insulating film 2.

The insulating layer 5 is a resin film, examples of which include a polyimide coverlay film. Note that a polyimide or epoxy-based resin material may be formed on the insulating layer 5 by printing, but a film is desirable for its flatness.

The heater wire 6 is arranged directly above the region between the pair of opposed electrode portions 4a. This heater wire 6 has a meande portion 6a formed directly above the thin film thermistor portion 3 so as to have a meander shape by being folded repeatedly, and a pair of heater base ends 6b extending with the tip end portions thereof being connected to the meande portion 6a and the base end portions thereof being arranged at the end of the insulating layer 5. Specifically, the meande portion 6a becomes the heating region of the heater wire 6, that is, a planar heating element, in other words, a planar film heater. Note that the pair of opposed electrode portions 4a and the meande portion 6a are shown in the cross-sectional view of FIG. 2 with their numbers reduced.

Furthermore, except for the end of the insulating film 2 including the base sides of the pair of linear extending portions 4b and the heater base ends 6b, a polyimide coverlay film 7 is pressure bonded to the insulating film 2. Instead of the polyimide coverlay film 7, a polyimide or epoxy-based resin material may be formed on the insulating film 2 by printing.

The thin film thermistor portion 3 consists of a Ti-Al-N thermistor material. In particular, the thin film thermistor portion 3 consists of a metal nitride represented by the general formula: $Ti_xAl_yN_z$ (where $0.70 \leq y/(x+y) \leq 0.95$, $0.4 \leq z \leq 0.5$, and $x+y+z = 1$), wherein the crystal structure thereof is a hexagonal wurtzite-type single phase.

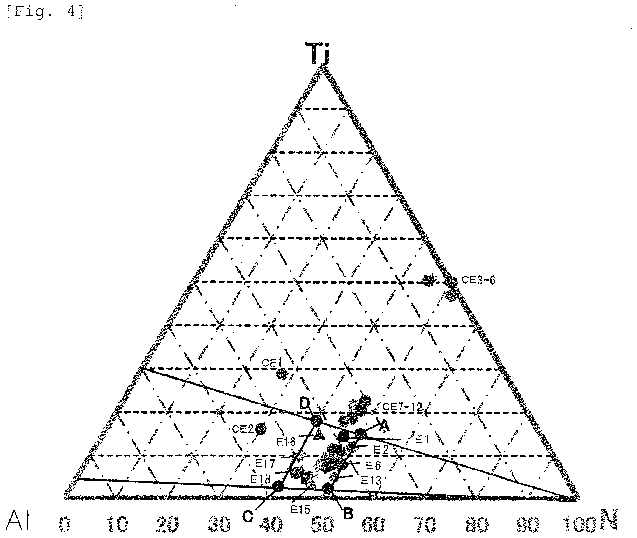

As described above, the thin film thermistor portion 3 is made of a metal nitride material consisting of a metal nitride represented by the general formula: $Ti_xAl_yN_z$ (where $0.70 \leq y/(x+y) \leq 0.95$, $0.4 \leq z \leq 0.5$, and $x+y+z = 1$), wherein the crystal structure thereof is a wurtzite-type (space group: $P6_3mc$ (No. 186)) single phase having a hexagonal crystal system. Specifically, this metal nitride material consists of a metal nitride having a composition within the region enclosed by the points A, B, C, and D in the Ti-Al-N-based ternary phase diagram as shown in FIG. 4, wherein the crystal phase thereof is wurtzite-type.

Note that the composition ratios of (x, y, z) (at%) at the points A, B, C, and D are A (15, 35, 50), B (2.5, 47.5, 50), C (3, 57, 40), and D (18, 42, 40), respectively.

Also, the thin film thermistor portion 3 is deposited as a film, and is a columnar crystal extending in a vertical direction with respect to the surface of the film. Furthermore, it is preferable that the material of the thin film thermistor portion 3 is more strongly oriented along the c-axis than the a-axis in a vertical direction with respect to the surface of the film.

Note that the decision about whether the material of the thin film thermistor portion 3 has a strong a-axis orientation (100) or a strong c-axis orientation (002) in a vertical direction with respect to the surface of the film (film thickness direction) is determined by examining the orientation of the crystal axis using X-ray diffraction (XRD). When the peak intensity ratio of "the peak intensity of (100) "/"the peak intensity of (002) ", where (100) is the Miller index indicating a-axis orientation and (002) is the Miller index indicating c-axis orientation, is less than 1, the material of the thin film thermistor portion 3 is determined to have a strong c-axis orientation.

The tips of lead wires 13 are soldered to each of terminal portions 4c of the pair of pattern electrodes 4 (the base end portions of the pair of linear extending portions 4b) and each of terminal portions 6c of the heater wire 6 (the base end portions of the heater base ends 6b) as shown in FIG. 1. The pair of pattern electrodes 4 and the heater wire 6 are electrically connected to a temperature control apparatus 14 through the respectively corresponding lead wires 13. Note that the heater wire 6 is electrically connected to the temperature control apparatus 14 through an auxiliary battery 15.

The temperature of this battery 1 with a temperature control function is controlled precisely by the auxiliary battery 15 and the temperature control apparatus 14 using PID control or the like. In particular, a control such as suppressing the electrical current flow to the heater wire 6 is performed so that the temperature is not lowered less than 25 °C, where the discharge characteristic starts to deteriorate, and is not raised to 45 °C or higher, where an electrolytic solution starts to deteriorate, while predicting temperature rising.

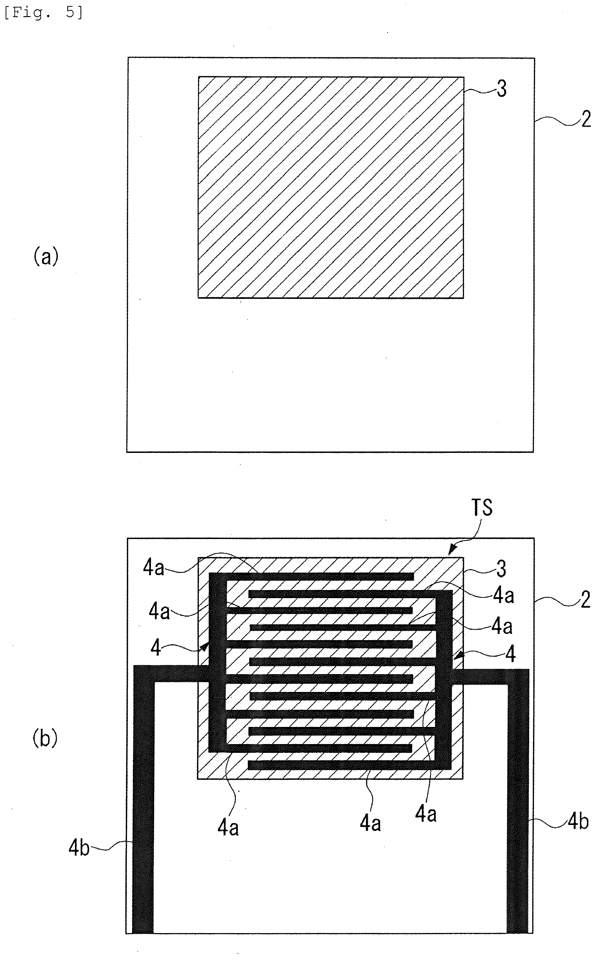

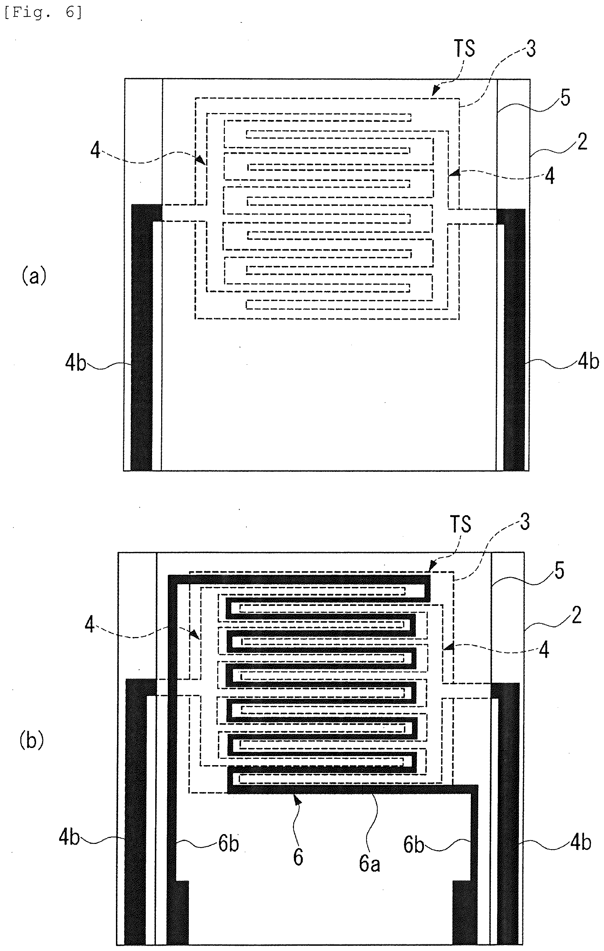

Hereinafter, a method for producing this battery 1 with a temperature control function will be described with reference to FIGs. 5 and 6.

Firstly, a method for producing the film heater 10 with a temperature sensor according to the present embodiment will be described. The method for producing this film heater 10 with a temperature sensor includes the steps of: forming a thin film thermistor portion for patterning the thin film thermistor portion 3 on the insulating film 2; forming an electrode for patterning the pair of pattern electrodes 4 on the insulating film 2 with the pair of opposed electrode portions 4a being arranged so as to be opposed to each other on the thin film thermistor portion 3; forming an insulating layer for forming the insulating layer 5 on the thin film thermistor portion 3 so as to cover the pair of pattern electrodes 4; forming a heater wire for patterning the heater wire 6 on the insulating layer 5; and forming a protective film for covering the entirety except for the ends of the pair of pattern electrodes 4 and the heater wire 6 with a polyimide coverlay film 7.

A more specific example of the method for producing the film heater 10 with a temperature sensor includes a step of depositing a thermistor material layer, which will be the thin film thermistor portion 3 consisting of $Ti_xAl_yN_z$ (where x = 9, y = 43, and z = 48), having a film thickness of 200 nm on the insulating film 2 made of a polyimide film having a thickness of 50 $\mu$m by a reactive sputtering method in a nitrogen-containing atmosphere using a Ti-Al alloy sputtering target. The sputtering conditions at this time are as follows: an ultimate vacuum: $5 \times 10^{-6}$ Pa, a sputtering gas pressure: 0.4 Pa, a target input power (output) : 200 W, and a percentage of nitrogen gas in a mixed gas (Ar gas + nitrogen gas) atmosphere: 20%.

Next, a resist solution was coated on the deposited thermistor material layer using a bar coater, and then pre-baking was performed for 1.5 minutes at a temperature of 110 °C. After exposure by an exposure device, any unnecessary portion was removed by a developing solution, and then patterning was performed by post-baking for 5 minutes at a temperature of 150 °C. Then, any unnecessary portion of the Ti-Al-N thermistor material layer was subject to wet etching using commercially available Ti etchant, and then the resist was stripped so as to form the thin film thermistor portion 3 as desired, as shown in FIG. 5(a).

Then, a bonding layer of a Cr film having a film thickness of 20 nm is formed on the thin film thermistor portion 3 and the insulating film 2 by a sputtering method. Furthermore, an electrode layer of an Au film having a film thickness of 100 nm is formed on this bonding layer by a sputtering method.

Next, a resist solution was coated on the deposited electrode layer using a bar coater, and then pre-baking was performed for 1.5 minutes at a temperature of 110 °C. After exposure by an exposure device, any unnecessary portion was removed by a developing solution, and then patterning was performed by post-baking for 5 minutes at a temperature of 150 °C. Then, any unnecessary electrode portion was subject to wet etching using commercially available Au etchant and Cr etchant in that order, and then the resist was stripped so as to form the pair of pattern electrodes 4 as desired, as shown in FIG. 5(b). In this way, the temperature sensor portion TS is produced.

Next, a polyimide coverlay film with an adhesive having a thickness of 12.5 $\mu$m is placed thereon so as to cover the thin film thermistor portion 3 together with the opposed electrode portions 4a, and then bonded to each other under pressurization of 2 MPa at a temperature of 150 °C for 10 minutes using a press machine to form the insulating layer 5, as shown in FIG. 6(a).

Furthermore, a Ni-Cr film having a thickness 500 nm, which will be the heater wire 6, is formed on the insulating layer 5 by a sputtering method using a metal mask. A resist solution is coated thereon using a bar coater, and then prebaking is performed for 1.5 minutes at a temperature of 110 °C. After exposure by an exposure device, any unnecessary portion is removed by a developing solution, and then pattering is performed by post baking for 5 minutes at a temperature of 150 °C.

After that, any unnecessary portion of the Ni-Cr film was subject to wet etching using commercially available Ni-Cr etchant, and then the resist was stripped so as to form the heater wire 6 having the meande portion 6a so as to be arranged between the pair of opposed electrode portions 4a of the thin film thermistor portion 3 through the insulating layer 5, as shown in FIG. 6(b). Note that, since the heater wire 6 has a big different thickness from the insulating layer 5, the entire heater wire 6 including the base end portions of the heater base ends 6b is formed on the insulating layer 5 in order to prevent the disconnection of the heater wire 6 due to the difference in level of the insulating layer 5.

Next, except for the base end portions of the pair of linear extending portions 4b and the heater base ends 6b, the polyimide coverlay film 7 with an adhesive having a thickness of 50 $\mu$m as a protective film is placed on the insulating film 2, and then bonded to each other under pressurization of 2 MPa at a temperature of 150 °C for 10 minutes using a press machine. This makes the entire thickness 150 $\mu$m.

Furthermore, Au plating having a thickness of 5 $\mu$m is applied on the terminal portions 4c and 6c of the pair of pattern electrodes 4 and the heater wire 6 respectively by electrolytic plating, and then lead wires 13 are soldered thereto to produce the film heater 10 with a temperature sensor.

When a plurality of batteries 1 with a temperature control function is simultaneously produced, a plurality of thin film thermistor portions 3, a plurality of pairs of pattern electrodes 4, and a plurality of heater wires 6 are formed on a large-format sheet of the insulating film 2 as described above, and then the resulting large-format sheet is cut into a plurality of segments so as to obtain a plurality of film heaters 10 with a temperature sensor.

In order to form the film heater 10 with a temperature sensor having a desired size depending on its use, the width and space of the meande portion 6a may be adjusted, and then the width and space of the pair of opposed electrode portions 4a of the thin film thermistor portion 3 may be accordingly adjusted to the size of the meande portion 6a so that the resistance value of the pair of opposed electrode portions 4a is matched to the desired value.

Next, this film heater 10 with a temperature sensor is bonded to the surface (one side) of the battery body B1 using a film 17 with double-faced adhesive, as shown in FIG. 2 and 3(b). Furthermore, as shown in FIG. 3(c), the outer periphery of the battery body B1 together with the film heater 10 with a temperature sensor is wrapped and covered with an insulating tape 16 to produce the battery 1 with a temperature control function.

As described above, since the battery 1 with a temperature control function of the present embodiment includes the film heater 10 with a temperature sensor having the temperature sensor portion TS and the heater wire 6, which is arranged so as to cover at least a part of the surface of the battery body B1, wherein the temperature sensor portion TS has the thin film thermistor portion 3, a temperature measurement and heating can be performed on a broad range of the surface of the battery body B1, whereby the temperature can be controlled with high accuracy and the circuit can be interrupted when abnormal heating occurs.

In addition, the average temperature of the entire heater wire 6 or the entire battery body B1 can be accurately measured by the thin film thermistor portion 3 arranged directly under the heating region of the heater wire 6. Also, since the thin film thermistor portion 3 is thinner and has a smaller volume as compared with a chip thermistor or a thermostat, the thin film thermistor portion 3 has an excellent responsivity and has few ruggedness on the surface. Consequently, the battery can be thinned as a whole and thus can be easily mounted and housed in a small space. Further, since the thin film thermistor portion 3 is formed directly under the heating region of the heater wire 6, the temperature sensor portion TS does not need to be provided in a place with no heater wire 6, whereby the area of the battery can be smaller as a whole.

Furthermore, since the film heater 10 with a temperature sensor can be easily and tightly bonded to the surface of the battery body B1 with high flexibility, a temperature can be measured with high accuracy and high responsivity.

Also, since the heater wire 6 is arranged directly above the region between the pair of opposed electrode portions 4a that is the temperature detection portion of the thin film thermistor portion 3, the temperature of the heater wire 6 can be measured with high accuracy.

In addition, since the thin film thermistor portion 3 consists of a metal nitride represented by the general formula: $Ti_xAl_yN_z$ (where $0.70 \leq y/(x+y) \leq 0.95$, $0.4 \leq z \leq 0.5$, and $x+y+z = 1$), wherein the crystal structure thereof is a wurtzite-type single phase having a hexagonal crystal system, a good B constant and a high heat resistance can be obtained without firing.

Further, since this metal nitride material is a columnar crystal extending in a vertical direction with respect to the surface of the film, the crystallinity of the film is high. Consequently, a high heat resistance can be obtained.

Furthermore, since this metal nitride material is more strongly oriented along the c-axis than the a-axis in a vertical direction with respect to the surface of the film, a high B constant as compared with the case of a strong a-axis orientation can be obtained.

In the method for producing the thermistor material layer (the thin film thermistor portion 3) of the present embodiment, since film deposition is performed by reactive sputtering in a nitrogen-containing atmosphere using a Ti-Al alloy sputtering target, the metal nitride material consisting of the aforementioned Ti-Al-N can be deposited on a film without firing.

In addition, when the sputtering gas pressure during the reactive sputtering is set to less than 0.67 Pa, a metal nitride material film, which is more strongly oriented along the c-axis than the a-axis in a vertical direction to the surface of the film, can be formed.

As described above, in the battery 1 with a temperature control function of the present embodiment, since the thin film thermistor portion 3 made of the above-described thermistor material layer is formed on the insulating film 2, the insulating film 2 having a low heat resistance, such as a resin film, can be used because the thin film thermistor portion 3 is formed without firing and has a high B constant and a high heat resistance. Consequently, a thin and flexible temperature sensor portion having a good thermistor characteristic can be obtained.

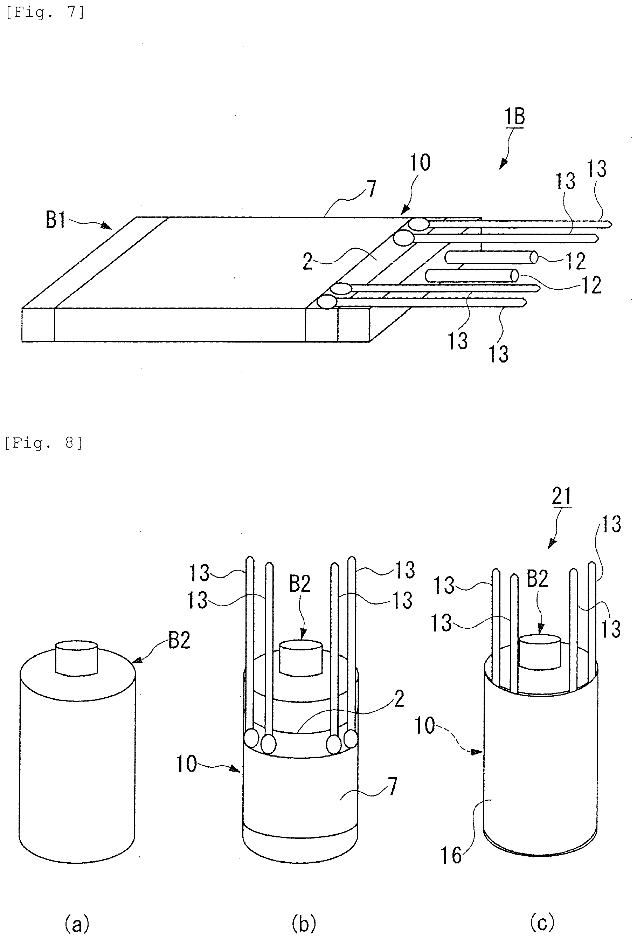

As another example of the first embodiment, as shown in FIG. 7, a battery 1B with a temperature control function may be produced in which the film heater 10 with a temperature sensor is bonded to the entire outer periphery of the battery body B1 so as to be wrapped, and the heater wire 6 and the thin film thermistor portion 3 extend so as to cover the entire outer periphery of the battery body B1.

In this case, since the heater wire 6 and the thin film thermistor portion 3 extend so as to cover the entire outer periphery of the battery body B1, the average temperature can be measured in the entire outer periphery of the battery body B1, and the average temperature of the battery body B1 can be measured with high accuracy. In particular, since the film heater 10 with a temperature sensor can be easily and tightly bonded to the outer periphery of the battery body B1 with high flexibility, the temperature can be measured with high accuracy and high responsivity.

Next, a battery with a temperature control function according to a second embodiment of the present invention will be described below with reference to FIG. 8. Note that, in the following description of the second embodiment, the same components as those in the first embodiment described above are denoted by the same reference numerals, and thus the description thereof is omitted.

The second embodiment is different from the first embodiment in the following point. In the first embodiment, the battery body B1 is a laminar secondary battery, whereas in a battery 21 with a temperature control function of the second embodiment, the battery body B2 is columnar secondary battery, in which the film heater 10 with a temperature sensor is bonded to the entire outer periphery of the battery body B2 so as to be wrapped, as shown in FIG. 8.

As described above, in the battery 21 with a temperature control function of the second embodiment, since the entire outer periphery of the battery body B2 is wrapped and covered with the film heater 10 with a temperature sensor, and the heater wire 6 and the thin film thermistor portion 3 extend to cover the entire outer periphery of the battery body B2, the average temperature in the entire outer periphery of the battery body B2 can be measured. In particular, the average temperature of the battery body B2 having a columnar shape and volume can be measured with high accuracy.

[Examples]

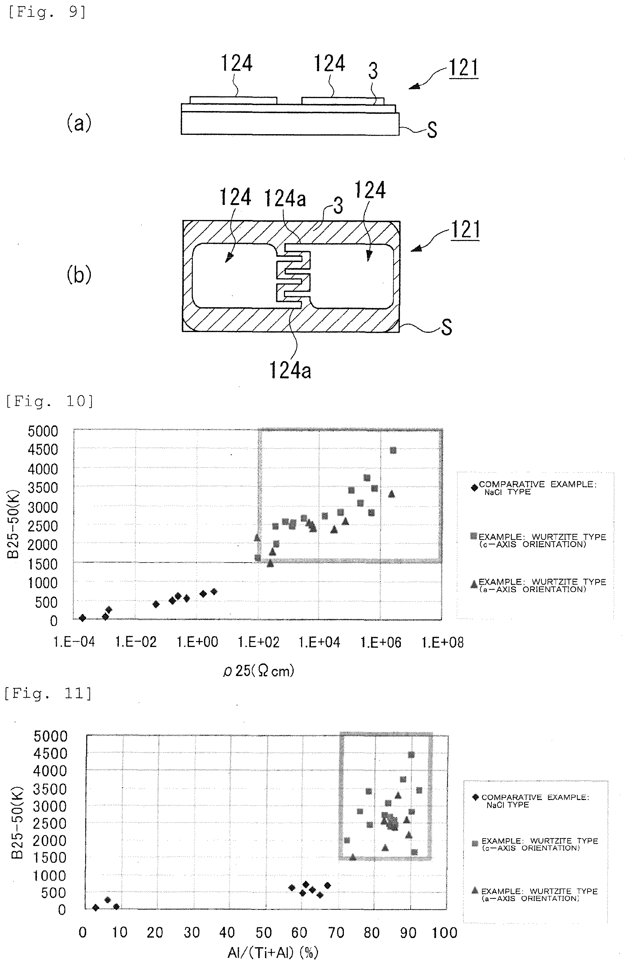

Next, the evaluation results of batteries with a temperature control function according to Examples produced based on the above embodiments regarding the battery with a temperature control function according to the present invention will be specifically described with reference to FIGs. 9 to 17 .

<Production of Film Evaluation Element>

The film evaluation elements 121 shown in FIG. 9 were produced as Examples and Comparative Examples in order to evaluate the thermistor material layer (the thin film thermistor portion 3) of the present invention.

Firstly, each of the thin film thermistor portions 3 having a thickness of 500 nm, which were made of the metal nitride materials with various composition ratios shown in Table 1, was formed on an Si wafer with a thermal oxidation film as an Si substrate S by a reactive sputtering method using Ti-Al alloy targets with various composition ratios. The sputtering conditions at this time are as follows: an ultimate vacuum: $5\times10^{-6}$ Pa, a sputtering gas pressure: 0.1 to 1 Pa, a target input power (output) : 100 to 500 W, and a percentage of nitrogen gas in a mixed gas (Ar gas + nitrogen gas) atmosphere: 10 to 100%.

Next, a Cr film having a thickness of 20 nm was formed and an Au film having a thickness of 200 nm was further formed on each of the thin film thermistor portions 3 by a sputtering method. Furthermore, a resist solution was coated on the stacked metal films using a spin coater, and then pre-baking was performed for 1.5 minutes at a temperature of 110 °C. After exposure by an exposure device, any unnecessary portion was removed by a developing solution, and then patterning was performed by post-baking for 5 minutes at a temperature of 150 °C. Then, any unnecessary electrode portion was subject to wet etching using commercially available Au etchant and Cr etchant, and then the resist was stripped so as to form the pair of pattern electrodes 124, each having the desired comb shaped electrode portion 124a. Then, the resultant elements were diced into chip elements so as to obtain film evaluation elements 121 used for evaluating a B constant and for testing heat resistance.

Note that the film evaluation elements 121 according to Comparative Examples, which have the composition ratios of $Ti_xAl_yN_z$ outside the range of the present invention and have different crystal systems, were similarly produced for comparative evaluation.

<Film Evaluation>

(1) Composition Analysis

Elemental analysis was performed by X-ray photoelectron spectroscopy (XPS) on the thin film thermistor portions 3 obtained by the reactive sputtering method. In the XPS, a quantitative analysis was performed on a sputtering surface at a depth of 20 nm from the outermost surface by Ar sputtering. The results are shown in Table 1. In the following tables, the composition ratios are expressed by "at%".

In the X-ray photoelectron spectroscopy (XPS), a quantitative analysis was performed under the conditions of an X-ray source of MgKa (350 W), a path energy of 58.5 eV, a measurement interval of 0.125 eV, a photo-electron take-off angle with respect to a sample surface of 45 degrees, and an analysis area of about 800 $\mu$m$\varphi$. Note that the quantitative accuracy of N/(Ti+Al+N) and Al/(Ti+Al) was $\pm$2% and $\pm$1%, respectively.

(2) Specific Resistance Measurement

The specific resistance of each of the thin film thermistor portions 3 obtained by the reactive sputtering method was measured by the four-probe method at a temperature of 25 °C. The results are shown in Table 1.

(3) Measurement of B Constant

The resistance values for each of the film evaluation elements 121 at temperatures of 25 °C and 50 °C were measured in a constant temperature bath, and a B constant was calculated based on the resistance values at temperatures of 25 °C and 50 °C. The results are shown in Table 1.

In the B constant calculating method of the present invention, a B constant is calculated by the following formula using the resistance values at temperatures of 25 °C and 50 °C as described above.

$$\mathrm{B\ constant\ (K)\ =\ ln(R25/R50)/(1/T25-1/T50)}$$

R25 (Ω): resistance value at 25 °C
R50 (Ω): resistance value at 50 °C
T25 (K): 298.15 K, which is an absolute temperature of 25 °C expressed in Kelvin
T50 (K): 323.15 K, which is an absolute temperature of 50 °C expressed in Kelvin

As can be seen from these results, a thermistor characteristic of a resistivity of 100 Ωcm or higher and a B constant of 1500 K or higher is achieved in all of the Examples in which the composition ratios of $Ti_xAl_yN_z$ fall within the region enclosed by the points A, B, C, and D in the ternary phase diagram shown in FIG. 4, i.e., the region where "0.70 ≤ y/(x+y) ≤ 0.95, 0.4 ≤ z ≤ 0.5, and x+y+z = 1".

A graph illustrating the relationship between a resistivity at 25 °C and a B constant obtained from the above results is shown in FIG. 10. In addition, a graph illustrating the relationship between an Al/(Ti+Al) ratio and a B constant is shown in FIG. 11. These graphs shows that the thin film thermistor portions 3, the composition ratios of which fall within the region where Al/(Ti+Al) is from 0.7 to 0.95 and N/(Ti+Al+N) is from 0.4 to 0.5 and each crystal system of which is a hexagonal wurtzite-type single phase, have a specific resistance value at a temperature of 25 °C of 100 Ωcm or higher and a B constant of 1500 K or higher, which are the regions realizing a high resistance and a high B constant. Note that, in data shown in FIG. 11, the reason why the B constant varies with respect to nearly the same Al/(Ti+Al) ratio is because the materials of the thin film thermistor portions 3 have different amounts of nitrogen in their crystals.

In the materials according to Comparative Examples 3 to 12 shown in Table 1, the composition ratios fall within the region where Al/(Ti+Al) < 0.7, and each crystal system thereof is a cubic NaCl-type phase. In the material according to Comparative Example 12 (Al/(Ti+Al) = 0.67), a NaCl-type phase and a wurtzite-type phase coexist. Thus, a material with the composition ratio that falls within the region where Al/(Ti+Al) < 0.7 has a specific resistance value at a temperature of 25 °C of less than 100 Ωcm and a B constant of less than 1500 K, which are the regions of low resistance and low B constant.

In the materials according to Comparative Examples 1 and 2 shown in Table 1, the composition ratios fall within the region where N/(Ti+Al+N) is less than 40%, that is, the materials are in a crystal state where nitridation of metals contained therein is insufficient. The materials according to Comparative Example 1 and 2 were neither a NaCl-type nor wurtzite-type phase and had very poor crystallinity. In addition, it was found that the materials according to these Comparative Examples exhibited near-metallic behavior because both the B constant and the resistance value were very small.

(4) Thin Film X-Ray Diffraction (Identification of Crystal Phase)

The crystal phases of the thin film thermistor portions 3 obtained by the reactive sputtering method were identified by Grazing Incidence X-ray Diffraction. The thin film X-ray diffraction is a small angle X-ray diffraction experiment. The measurement was performed under the conditions of a Cu X-ray tube, an incidence angle of 1 degree, and 2θ of from 20 to 130 degrees. Some of the samples were measured under the condition of an incidence angle of 0 degree and 2θ of from 20 to 100 degrees.

As a result of the measurement, a wurtzite-type phase (hexagonal, the same phase as that of Al-N) was obtained in the region where Al/(Ti+Al) ≥ 0.7, whereas a NaCl-type phase (cubic, the same phase as that of Cr) was obtained in the region where Al/(Ti+Al) < 0.65. In addition, two coexisting phases of a wurtzite-type phase and a NaCl-type phase were obtained in the region where 0.65 < Al/(Ti+Al) < 0.7.

Thus, in the Ti-Al-N-based material, the regions of high resistance and high B constant can be realized by the wurtzite-type phase having a composition ratio of Al/(Ti+Al) ≥ 0.7. In the Examples of the present invention, no impurity phase was confirmed and each crystal structure thereof was a wurtzite-type single phase.

In Comparative Examples 1 and 2 shown in Table 1, each crystal phase thereof was neither a wurtzite-type nor NaCl-type phase as described above, and thus, could not be identified in the testing. In these Comparative Examples, the peak width of XRD was very large, showing that the materials had very poor crystallinity. It is contemplated that the crystal phases thereof were metal phases with insufficient nitridation because they exhibited near-metallic behavior from the viewpoint of electric properties.

[Table 1]

| | CRYSTAL SYSTEM | XRD PEAK INTENSITY RATIO OF (100)/(002) WHEN CRYSTAL PHASE IS WURTZITE TYPE | CRYSTAL AXIS EXHIBITING STRONG DEGREE OF ORIENTATION IN VERTICAL DIRECTION WITH RESPECT TO SUBSTRATE SURFACE WHEN CRYSTAL PHASE IS WURTZITE TYPE (a-AXIS OR c-AXIS) | SPUTTERING GAS PRESSURE (Pa) | COMPOSITION RATIO | | | | RESULT OF ELECTRIC PROPERTIES | |
|---|---|---|---|---|---|---|---|---|---|---|
| | | | | | Ti(%) | Al(%) | N(%) | Al/(Ti+Al) (%) | B CONSTANT (K) | SPECIFIC RESISTANCE VALUE AT 25°C (Ω·cm) |
| COMPARATIVE EXAMPLE 1 | UNKNOWN (INSUFFICIENT NITRIDATION) | - | | - | 29 | 43 | 28 | 60 | <0 | 2.E-04 |
| COMPARATIVE EXAMPLE 2 | UNKNOWN (INSUFFICIENT NITRIDATION) | - | | - | 16 | 54 | 30 | 77 | 25 | 4.E-04 |
| COMPARATIVE EXAMPLE 3 | NaCl TYPE | - | | - | 50 | 0 | 50 | 0 | <0 | 2.E-05 |
| COMPARATIVE EXAMPLE 4 | NaCl TYPE | - | | - | 47 | 1 | 52 | 3 | 30 | 2.E-04 |
| COMPARATIVE EXAMPLE 5 | NaCl TYPE | - | | - | 51 | 3 | 46 | 6 | 248 | 1.E-03 |
| COMPARATIVE EXAMPLE 6 | NaCl TYPE | - | | - | 50 | 5 | 45 | 9 | 69 | 1.E-03 |
| COMPARATIVE EXAMPLE 7 | NaCl TYPE | - | | - | 23 | 30 | 47 | 57 | 622 | 3.E-01 |
| COMPARATIVE EXAMPLE 8 | NaCl TYPE | - | | - | 22 | 33 | 45 | 60 | 477 | 2.E-01 |
| COMPARATIVE EXAMPLE 9 | NaCl TYPE | - | | - | 21 | 32 | 47 | 61 | 724 | 4.E+00 |
| COMPARATIVE EXAMPLE 10 | NaCl TYPE | - | | - | 20 | 34 | 46 | 63 | 564 | 5.E-01 |
| COMPARATIVE EXAMPLE 11 | NaCl TYPE | - | | - | 19 | 35 | 46 | 65 | 402 | 5.E-02 |
| COMPARATIVE EXAMPLE 12 | NaCl TYPE + WURTZITE TYPE | - | | - | 18 | 37 | 45 | 67 | 665 | 2.E+00 |
| EXAMPLE 1 | WURTZITE TYPE | 0.05 | c-AXIS | <0.67 | 15 | 38 | 47 | 72 | 1980 | 4.E+02 |
| EXAMPLE 2 | WURTZITE TYPE | 0.07 | c-AXIS | <0.67 | 12 | 38 | 50 | 76 | 2798 | 5.E+04 |
| EXAMPLE 3 | WURTZITE TYPE | 0.45 | c-AXIS | <0.67 | 11 | 42 | 47 | 79 | 3365 | 1.E+05 |
| EXAMPLE 4 | WURTZITE TYPE | <0.01 | c-AXIS | <0.67 | 11 | 41 | 48 | 79 | 2437 | 4.E+02 |
| EXAMPLE 5 | WURTZITE TYPE | 0.34 | c-AXIS | <0.67 | 9 | 43 | 48 | 83 | 2727 | 2.E+04 |
| EXAMPLE 6 | WURTZITE TYPE | <0.01 | c-AXIS | <0.67 | 8 | 42 | 50 | 84 | 3057 | 2.E+05 |
| EXAMPLE 7 | WURTZITE TYPE | 0.09 | c-AXIS | <0.67 | 8 | 44 | 48 | 84 | 2665 | 3.E+03 |
| EXAMPLE 8 | WURTZITE TYPE | 0.05 | c-AXIS | <0.67 | 8 | 44 | 48 | 85 | 2527 | 1.E+03 |
| EXAMPLE 9 | WURTZITE TYPE | <0.01 | c-AXIS | <0.67 | 8 | 45 | 47 | 86 | 2557 | 8.E+02 |
| EXAMPLE 10 | WURTZITE TYPE | 0.04 | c-AXIS | <0.67 | 8 | 46 | 46 | 86 | 2449 | 1.E+03 |
| EXAMPLE 11 | WURTZITE TYPE | 0.24 | c-AXIS | <0.67 | 7 | 48 | 45 | 88 | 3729 | 4.E+05 |
| EXAMPLE 12 | WURTZITE TYPE | 0.73 | c-AXIS | <0.67 | 5 | 49 | 46 | 90 | 2798 | 5.E+05 |
| EXAMPLE 13 | WURTZITE TYPE | <0.01 | c-AXIS | <0.67 | 5 | 45 | 50 | 90 | 4449 | 3.E+06 |
| EXAMPLE 14 | WURTZITE TYPE | 0.38 | c-AXIS | <0.67 | 5 | 50 | 45 | 91 | 1621 | 1.E+02 |
| EXAMPLE 15 | WURTZITE TYPE | 0.13 | c-AXIS | <0.67 | 4 | 50 | 46 | 93 | 3439 | 6.E+05 |
| EXAMPLE 16 | WURTZITE TYPE | 3.54 | a-AXIS | ≧0.67 | 15 | 43 | 42 | 74 | 1507 | 3.E+02 |
| EXAMPLE 17 | WURTZITE TYPE | 2.94 | a-AXIS | ≧0.67 | 10 | 49 | 41 | 83 | 1794 | 3.E+02 |
| EXAMPLE 18 | WURTZITE TYPE | 1.05 | a-AXIS | ≧0.67 | 6 | 52 | 42 | 90 | 2164 | 1.E+02 |
| EXAMPLE 19 | WURTZITE TYPE | 2.50 | a-AXIS | ≧0.67 | 9 | 44 | 47 | 83 | 2571 | 5.E+03 |
| EXAMPLE 20 | WURTZITE TYPE | 9.09 | a-AXIS | ≧0.67 | 8 | 46 | 46 | 84 | 2501 | 6.E+03 |
| EXAMPLE 21 | WURTZITE TYPE | 6.67 | a-AXIS | ≧0.67 | 8 | 45 | 47 | 86 | 2408 | 7.E+03 |
| EXAMPLE 22 | WURTZITE TYPE | 2.22 | a-AXIS | ≧0.67 | 8 | 46 | 46 | 84 | 2364 | 3.E+04 |
| EXAMPLE 23 | WURTZITE TYPE | 1.21 | a-AXIS | ≧0.67 | 7 | 46 | 47 | 87 | 3317 | 2.E+06 |
| EXAMPLE 24 | WURTZITE TYPE | 3.33 | a-AXIS | ≧0.67 | 6 | 51 | 43 | 89 | 2589 | 7.E+04 |

Next, since all the materials according to the Examples of the present invention were wurtzite-type phase films having strong orientation, whether the films have a strong a-axis orientation or c-axis orientation of the crystal axis in a vertical direction (film thickness direction) with respect to the Si substrate S was examined by XRD. At this time, in order to examine the orientation of the crystal axis, the peak intensity ratio of (100) / (002) was measured, where (100) is the Miller index indicating a-axis orientation and (002) is the Miller index indicating c-axis orientation.

As a result of the measurement, in the Examples in which film deposition was performed at a sputtering gas pressure of less than 0.67 Pa, the intensity of (002) was much stronger than that of (100), that is, the films exhibited stronger c-axis orientation than a-axis orientation. On the other hand, in the Examples in which film deposition was performed at a sputtering gas pressure of 0.67 Pa or higher, the intensity of (100) was much stronger than that of (002), that is, the films exhibited stronger a-axis orientation than c-axis orientation.

Note that it was confirmed that a wurtzite-type single phase was formed in the same manner even when the thin film thermistor portion 3 was deposited on a polyimide film under the same deposition condition. It was also confirmed that the crystal orientation did not change even when the thin film thermistor portion 3 was deposited on a polyimide film under the same deposition condition.

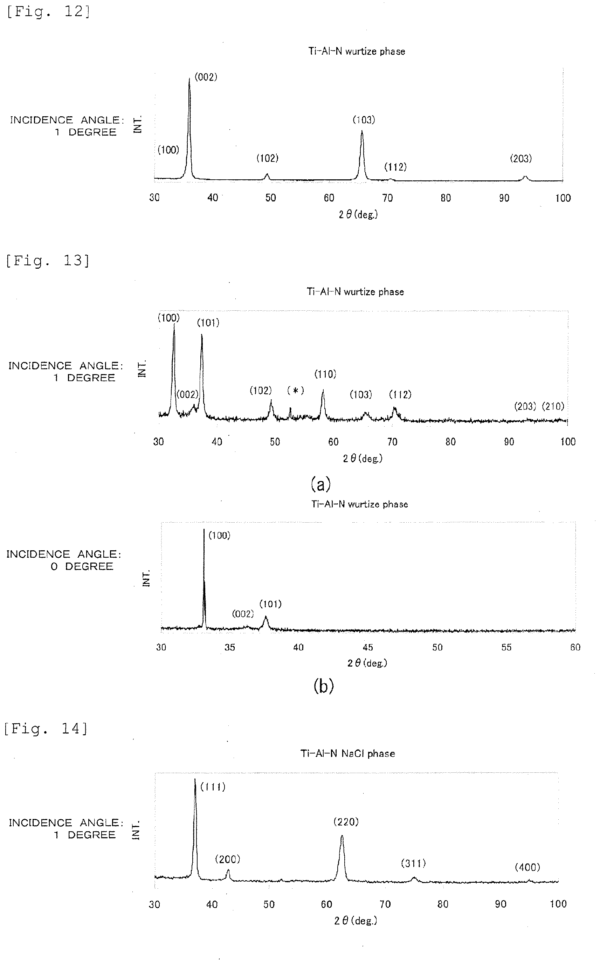

An exemplary XRD profile of the material according to the Example exhibiting strong c-axis orientation is shown in FIG. 12. In this Example, Al/(Ti+Al) was equal to 0.84 (wurtzite-type, hexagonal), and the measurement was performed at an incidence angle of 1 degree. As can be seen from the result, the intensity (100) was much stronger than that of (002) in this Example.

In addition, an exemplary XRD profile of the material according to the Example exhibiting strong a-axis orientation is shown in FIG. 13. In this Example, Al/(Ti+Al) was equal to 0.83 (wurtzite-type, hexagonal), the measurement was performed at an incidence angle of 1 degree. As can be seen from the result, the intensity of (100) was much stronger than that of (002) in this Example.

Furthermore, the symmetrical measurement was performed at an incidence angle of 0 degree in this Example. It was confirmed that the peak with the asterisk (*) in the graph was a peak originating from the device, and thus, the peak with the asterisk (*) in the graph was neither a peak originating from a sample itself nor a peak originating from an impurity phase (which could also be confirmed from the fact that the peak with (*) was lost in the symmetrical measurement).

An exemplary XRD profile of the material according to a Comparative Example is shown in FIG. 14. In this Comparative Example, Al/(Ti+Al) was equal to 0.6 (NaCl type, cubic), and the measurement was performed at an incidence angle of 1 degree. No peak which could be indexed as a wurtzite-type (space group: $P6_3mc$ (No. 186)) was detected, and thus, the material according to this Comparative Example was confirmed as a NaCl-type single phase.

Next, the correlations between a crystal structure and its electric properties were further compared with each other in detail regarding the Examples of the present invention in which the wurtzite-type materials were employed.

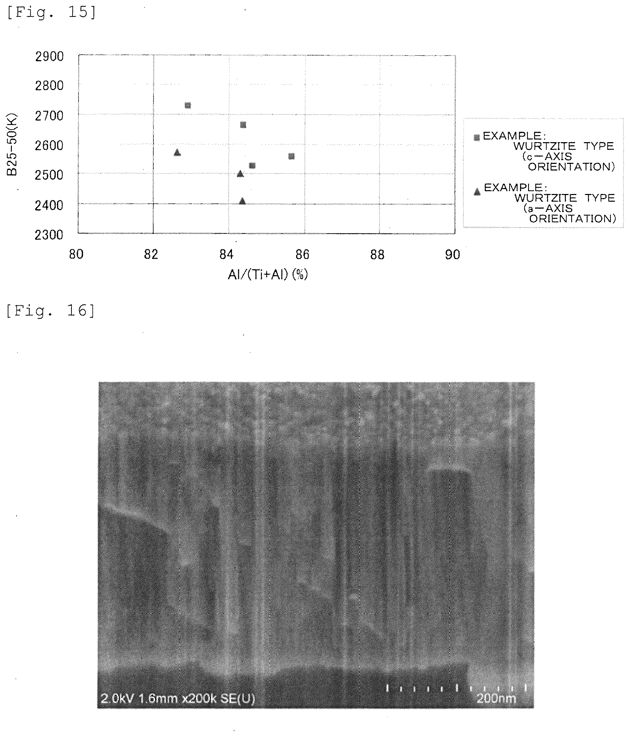

As shown in Table 2 and FIG. 15, the crystal axis of some materials (Examples 5, 7, 8, and 9) is strongly oriented along a c-axis in a vertical direction with respect to the surface of the substrate and that of other materials (Examples 19, 20, and 21) is strongly oriented along an a-axis in a vertical direction with respect to the surface of the substrate among the materials having nearly the same Al/(Ti+Al) ratio.

When both groups were compared to each other, it was found that the materials having a strong c-axis orientation had a higher B constant by about 100 K than that of the materials having a strong a-axis orientation provided that they have nearly the same Al/(Ti+Al) ratio. When focus was placed on the amount of N (N/(Ti+Al+N)), it was found that the materials having a strong c-axis orientation had a slightly larger amount of nitrogen than that of the materials having a strong a-axis orientation. Since the ideal stoichiometric ratio of N/(Ti+Al+N) is 0.5, it was found that the materials having a strong c-axis orientation were ideal materials due to a small amount of nitrogen defects.

[Table 2]

| | CRYSTAL SYSTEM | XRD PEAK INTENSITY RATIO OF (100)/ (002) WHEN CRYSTAL PHASE IS WURTZITE TYPE | CRYSTAL AXIS EXHIBITING STRONG DEGREE OF ORIENTATION IN VERTICAL DIRECTION WITH RESPECT TO SUBSTRATE SURFACE WHEN CRYSTAL PAHSE IS WURTZITE TYPE (a-AXIS OR c-AXIS) | SPUTTERING GAS PRESSURE (Pa) | COMPOSITION RATIO | | | | RESULT OF ELECTRIC PROPERTIES | |
|---|---|---|---|---|---|---|---|---|---|---|
| | | | | | Ti (%) | Al (%) | N (%) | Al/ (Ti+Al) (%) | B CONSTANT (K) | SPECIFIC RESISTANCE VALUE AT 25 °C ($\Omega$cm) |
| EXAMPLE 5 | WURTZITE TYPE | 0.34 | c-AXIS | <0.67 | 9 | 43 | 48 | 83 | 2727 | 2.E+04 |
| EXAMPLE 7 | WURTZITE TYPE | 0.09 | c-AXIS | <067 | 8 | 44 | 48 | 84 | 2665 | 3.E+03 |
| EXAMPLE 8 | WURTZITE TYPE | 0.05 | c-AXIS | <0.67 | 8 | 44 | 48 | 85 | 2527 | 1.E+03 |
| EXAMPLE 9 | WURTZITE TYPE | <0.01 | c-AXIS | <0 67 | 8 | 45 | 47 | 86 | 2557 | 8E+02 |
| EXAMPLE 19 | WURTZITE TYPE | 2.50 | a-AXIS | $\geqq$ 0.67 | 9 | 44 | 47 | 83 | 2571 | 5.E+03 |
| EXAMPLE 20 | WURTZITE TYPE | 9.09 | a-AXIS | $\geqq$ 0.67 | 8 | 46 | 46 | 84 | 2501 | 6.E-03 |
| EXAMPLE 21 | WURTZITE TYPE | 6.67 | a-AXIS | $\geqq$0.67 | 8 | 45 | 47 | 84 | 2408 | 7.E+03 |

<Crystal Form Evaluation>

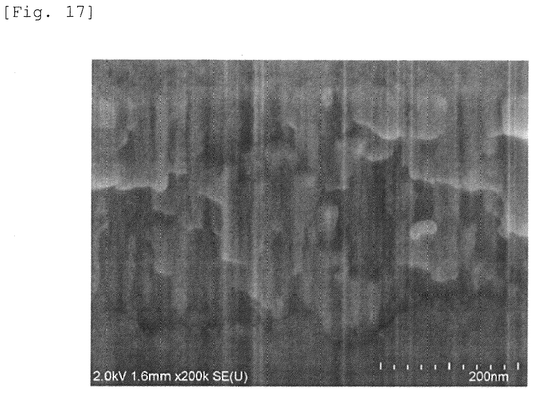

Next, as an exemplary crystal form in the cross-section of the thin film thermistor portion 3, a cross-sectional SEM photograph of the thin film thermistor portion 3 according to the Example (where Al/(Ti+Al) = 0.84, hexagonal wurtzite-type, and strong c-axis orientation), which is deposited on the Si substrate S with a thermal oxidation film, is shown in FIG. 16. In addition, a cross-sectional SEM photograph of the thin film thermistor portion 3 according to another Example (where Al/(Ti+Al) = 0.83, hexagonal wurtzite-type, and strong a-axis orientation) is shown in FIG. 17.

The samples of these Examples were obtained by breaking the Si substrates S by cleavage. The photographs were taken by tilt observation at an angle of 45 degrees.

As can be seen from these photographs, the samples were formed of high-density columnar crystals in all of the Examples. Specifically, the growth of columnar crystals in a vertical direction with respect to the surface of the substrate was observed both in the Examples revealing a strong c-axis orientation and in the Examples revealing a strong a-axis orientation. Note that the break of the columnar crystals was generated upon breaking the Si substrate S by cleavage.

<Heat Resistance Test Evaluation>

In the Examples and Comparative Example shown in Table 3, a resistance value and a B constant before and after the heat resistance test at a temperature of 125 °C for 1000 hours in air were evaluated. The results are shown in Table 3. A conventional Ta-Al-N-based material according to a Comparative Example was also evaluated in the same manner for comparison.

As can be seen from these results, although the Al concentration and the nitrogen concentration vary, the heat resistance of the Ti-Al-N-based material based on the electric properties change before and after the heat resistance test is more excellent than that of the Ta-Al-N-based material according to the Comparative Example when comparison is made by using the materials according to the Examples having the same B constant as that of the Ta-Al-N-based material according to the Comparative Example. Note that the materials according to Examples 5 and 8 have a strong c-axis orientation, and the materials according to Examples 21 and 24 have a strong a-axis orientation. When both groups were compared to each other, the heat resistance of the materials according to the Examples revealing a strong c-axis orientation is slightly improved as compared with that of the materials according to the Examples revealing a strong a-axis orientation.

Note that, in the Ta-Al-N-based material, the ionic radius of Ta is much larger than that of Ti and Al, and thus, a wurtzite-type phase cannot be produced in the high-concentration Al region. It is contemplated that the Ti-Al-N-based material having a wurtzite-type phase has better heat resistance than the Ta-Al-N-based material because the Ta-Al-N-based material is not a wurtzite-type phase.

[Table 3]

| | M ELEMENT | M (%) | A l (%) | N (%) | Al/ (M+Al) (%) | B25-50 (K) | SPECIFIC RESISTANCE VALUE AT 25 °C ($\Omega$cm) | RISING RATE OF SPECIFIC RESISTANCE AFTER AT RESISTANCE TEST AT 125 °C FOR 1.000 HOURS (%) | RISING RATE OF B CONSTANT AFTER HEAT RESISTANCE TEST AT 125 °C FOR 1,000 HOURS (%) |
|---|---|---|---|---|---|---|---|---|---|
| COMPARATIVE EXAMPLE | Ta | 60 | 1 | 39 | 2 | 2671 | 5.E+02 | 25 | 16 |
| EXAMPLE 5 | Ti | 9 | 43 | 48 | 83 | 2727 | 2.E+04 | < 4 | < 1 |
| EXAMPLE 8 | Ti | 8 | 44 | 48 | 85 | 2527 | 1.E+03 | <4 | < 1 |
| EXAMPLE 21 | Ti | 8 | 45 | 47 | 84 | 2408 | 7.E+03 | < 5 | < 1 |
| EXAMPLE 24 | Ti | 6 | 51 | 43 | 89 | 2599 | 7.E+04 | < 5 | < 1 |

For example, in each embodiment described above, the thin film thermistor portion consisting of the aforementioned Ti-Al-N is preferred, but the thin film thermistor portion made of another thermistor material may be employed. In addition, the pair of pattern electrodes is formed on the thin film thermistor portion, but the pair of pattern electrodes may be formed under the thin film thermistor portion.

Note that the effect of the positional relationship between the thin film thermistor portion and the heater wire as to which is located above or under the other will not be changed except for bending. However, in view of bending, since the reliability to bending will be improved when the thin film thermistor portion made of a thermistor material layer consisting of a nitride or the like is located on the flat surface of the insulating film, it is desired that the thin film thermistor portion is located under the heater wire.

[Reference Numerals]

1, 1B, 21: battery with a temperature control function, 2: insulating film, 3: thin film thermistor portion, 4: pattern electrode, 4a: opposed electrode portion, 5: insulating layer, 6: heater wire, 10: film heater with a temperature sensor, B1, B2: battery body, TS: temperature sensor portion

**Claims**

1. A battery with a temperature control function, comprising:

   a battery body; and
   a film heater with a temperature sensor (10) arranged so as to cover at least a part of the surface of the battery body,
   wherein the film heater with a temperature sensor (10) includes:

   an insulating film (2);
   one of a temperature sensor portion (TS) and a heater wire (6) formed on the insulating film (2); and
   the other of the temperature sensor portion (TS) and the heater wire (6) formed through an insulating layer (5) on the one other than the other, wherein
   the heater wire (6) is patterned on the insulating film (2) or the insulating layer (5), and
   the temperature sensor portion (TS) has a thin film thermistor portion (3) made of a thermistor material patterned directly under or above the heating region of the heater wire (6) and on the insulating film (2) or the insulating layer (5), and a pair of pattern electrodes formed at least on or under the thin film thermistor portion (3).

2. The battery with a temperature control function according to claim 1, wherein the heater wire (6) and the thin film thermistor portion (3) extend so as to cover the entire outer periphery of the battery body.

3. The battery with a temperature control function according to claim 1, wherein
   the temperature sensor portion (TS) has the thin film thermistor portion (3) made of a thermistor material patterned on the insulating film (2), and the pair of pattern electrodes formed at least on or under the thin film thermistor portion (3), and
   the heater wire (6) is patterned on the insulating layer(5) formed on the thin film thermistor portion (3).

4. The battery with a temperature control function according to claim 1, wherein the thin film thermistor portion (3) consists of a metal nitride represented by the general formula: $Ti_xAl_yN_z$ (where $0.70 \leq y/(x+y) \leq 0.95$, $0.4 \leq z \leq 0.5$, and $x+y+z = 1$), wherein the crystal structure thereof is a hexagonal wurtzite-type single phase.

**Patentansprüche**

1. Batterie mit einer Temperatursteuerungsfunktion, umfassend:

   einen Batteriekörper; und
   einen Filmheizer mit einem Temperatursensor (10), der angeordnet ist, um mindestens einen Teil der Oberfläche des Batteriekörpers abzudecken,
   wobei der Filmheizer mit einem Temperatursensor (10) beinhaltet:

einen Isolierfilm (2);

einen von einem Temperatursensorabschnitt (TS) und einem Heizdraht (6), der auf dem Isolierfilm (2) gebildet ist; und

den anderen von dem Temperatursensorabschnitt (TS) und dem Heizdraht (6), der durch eine Isolierschicht (5) hindurch auf dem anderen als dem anderen gebildet ist, wobei

der Heizdraht (6) auf dem Isolierfilm (2) oder der Isolierschicht (5) strukturiert ist, und

der Temperatursensorabschnitt (TS) einen Dünnfilm-Thermistorabschnitt (3) aufweist, der aus einem Thermistormaterial gefertigt ist, das direkt unter oder über der Heizregion des Heizdrahts (6) und auf dem Isolierfilm (2) oder der Isolierschicht (5) strukturiert ist, und ein Paar von Strukturelektroden, das mindestens auf oder unter dem Dünnfilm-Thermistorabschnitt (3) gebildet ist.

2. Batterie mit einer Temperatursteuerungsfunktion nach Anspruch 1, wobei sich der Heizdraht (6) und der Dünnfilm-Thermistorabschnitt (3) derart erstrecken, dass sie den gesamten äußeren Umfang des Batteriekörpers abdecken.

3. Batterie mit einer Temperatursteuerungsfunktion nach Anspruch 1, wobei
der Temperatursensorabschnitt (TS) den Dünnfilm-Thermistorabschnitt (3), der aus einem Thermistormaterial gefertigt ist, das auf dem Isolierfilm (2) strukturiert ist, und das Paar von Strukturelektroden, das mindestens auf oder unter dem Dünnfilm-Thermistorabschnitt (3) gebildet ist, aufweist und
der Heizdraht (6) auf der Isolierschicht (5) strukturiert ist, die auf dem Dünnfilm-Thermistorabschnitt (3) gebildet ist.

4. Batterie mit einer Temperatursteuerungsfunktion nach Anspruch 1, wobei der Dünnfilm-Thermistorabschnitt (3) aus einem Metallnitrid besteht, das durch die folgende allgemeine Formel dargestellt ist: $Ti_xAl_yN_z$ (wobei $0{,}70 \leq y/(x+y) \leq 0{,}95$, $0{,}4 \leq z \leq 0{,}5$ und $x+y+z = 1$) sind, wobei die dessen Kristallstruktur eine hexagonale Wurtzit-artige Einzelphase ist.

## Revendications

1. Batterie ayant une fonction de régulation de température, comprenant :

un corps de batterie ; et
un élément chauffant en film ayant un capteur de température (10) agencé de manière à couvrir au moins une partie de la surface du corps de batterie,
dans laquelle l'élément chauffant en film ayant un capteur de température (10) inclut :

un film isolant (2) ;
l'un d'une partie de capteur de température (TS) et d'un fil chauffant (6) formé sur le film isolant (2) ; et
l'autre de la partie de capteur de température (TS) et du fil chauffant (6) formé à travers une couche isolante (5) sur l'autre que l'autre, dans laquelle

le fil chauffant (6) est structuré sur le film isolant (2) ou la couche isolante (5), et
la partie de capteur de température (TS) comporte une partie de thermistance à film mince (3) composée d'un matériau de thermistance structuré directement sous ou au-dessus de la région de chauffage du fil chauffant (6) et sur le film isolant (2) ou la couche isolante (5), et une paire d'électrodes à motifs formées au moins sur ou sous la partie de thermistance à film mince (3).

2. Batterie ayant une fonction de régulation de température selon la revendication 1, dans laquelle le fil chauffant (6) et la partie de thermistance à film mince (3) s'étendent de manière à couvrir toute la périphérie extérieure du corps de batterie.

3. Batterie ayant une fonction de régulation de température selon la revendication 1, dans laquelle
la partie de capteur de température (TS) comporte la partie de thermistance à film mince (3) composée d'un matériau de thermistance structuré sur le film isolant (2), et la paire d'électrodes à motifs formées au moins sur ou sous la partie de thermistance à film mince (3), et
le fil chauffant (6) est structuré sur la couche isolante (5) formée sur la partie de thermistance à film mince (3).

4. Batterie ayant une fonction de régulation de température selon la revendication 1, dans laquelle la partie de thermistance à film mince (3) est constituée d'un nitrure de métal représenté par la formule générale : $Ti_xAl_yN_z$ (où $0,70 \leq y/(x+y) \leq 0,95$, $0,4 \leq z \leq 0,5$, et $x+y+z = 1$), dans laquelle la structure cristalline de celle-ci est une phase simple de type wurtzite hexagonale.

[Fig. 1]

[Fig. 2]

[Fig. 3]

(a)

(b)

(c)

[Fig. 4]

[Fig. 5]

(a)

(b)

[Fig. 6]

(a)

(b)

[Fig. 7]

[Fig. 8]

(a)                    (b)                    (c)

[Fig. 9]

(a)

(b)

[Fig. 10]

[Fig. 11]

[Fig. 12]

Ti-Al-N wurtize phase

INCIDENCE ANGLE:
1 DEGREE

[Fig. 13]

Ti-Al-N wurtize phase

INCIDENCE ANGLE:
1 DEGREE

(a)

Ti-Al-N wurtize phase

INCIDENCE ANGLE:
0 DEGREE

(b)

[Fig. 14]

Ti-Al-N NaCl phase

INCIDENCE ANGLE:
1 DEGREE

[Fig. 15]

[Fig. 16]

[Fig. 17]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011138672 A
- JP 2006156024 A
- JP 2010245031 A
- EP 1333521 A
- US 20080198897 A